# EUROPEAN PATENT APPLICATION

(11) **EP 1 204 231 A1**
(43) Date of publication of application: **08.05.2002**
(21) Application number: 01250357.9
(22) Date of filing: 12.10.2001
(51) Int. Cl.: H04H 1/00

(54) **Broadcast program search method in digital broadcasting radio receiving apparatus, and computer-readable recording medium recording broadcast program search program**

(30) Priority: 16.10.2000 JP 2000315674
(71) Applicant: NEC CORPORATION, Tokyo (JP)
(72) Inventor: Kamei, Takayuki, c/o NEC IC Microcomp. Systems Ltd, Kawasaki-shi, Kanagawa (JP)
(74) Representative: Patentanwälte Wenzel & Kalkoff

(57) **Abstract**

A broadcast program search method in a digital broadcasting radio receiving apparatus includes the step of activating the broadcast program search program and switching to a broadcast program search mode, the step of selecting a search item and setting the search condition of the search item by an operation by a user, the search step of performing search by the search item selected by the user on the basis of the selection of the search item and the set search condition of the search item, the channel selection step of selecting a channel on the basis of the search result in the search step, and the step of checking whether to perform search again if the search is unsuccessful, repeating the setting under the set search condition if search is to be performed again, and terminating the broadcast program search program if no search is to be performed again. A computer-readable storage medium recording a broadcast program search program for a digital broadcasting radio receiving apparatus is also disclosed. This storage medium includes processes equivalent to the steps of the above-mentioned broadcast program search method.

## Description

### BACKGROUND OF THE INVENTION

### FIELD OF THE INVENTION:

The present invention relates to a broadcast program search method in a broadcast receiving apparatus for receiving a broadcast wave centering around DAB (Digital Audio Broadcasting) carried out in Europe, i.e., a broadcast wave which multiplexes a plurality of broadcast programs each containing audio data and broadcast program information and, more particularly, to a broadcast program search method in a digital broadcasting radio receiving apparatus by which a user can efficiently find a desired broadcast program, and a computer-readable recording medium recording a broadcast program search program.

### DESCRIPTION OF THE PRIOR ART:

Japanese Unexamined Patent Publication No. 10-107669 describes an example of a broadcast receiving apparatus for receiving a broadcast wave such as DAB, i.e., a broadcast wave which multiplexes a plurality of broadcast programs each containing audio data and broadcast program information. In the DAB broadcasting system, several broadcast programs (called services) are multiplexed on a certain frequency (called an ensemble), and several different broadcast contents (called service components) are contained in these broadcast programs.

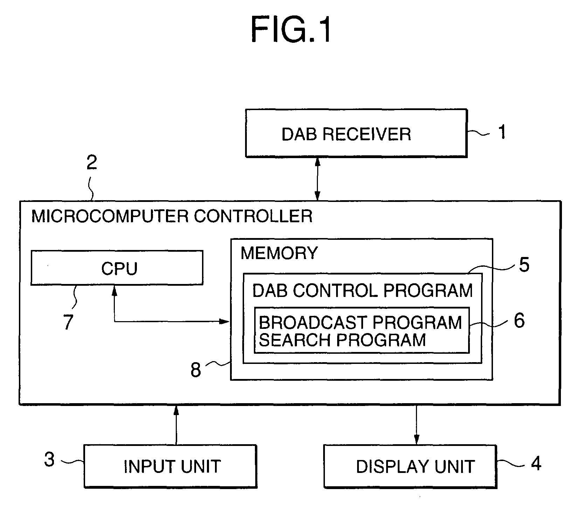

As shown in Fig. 1, a conventional broadcast receiving apparatus includes a DAB receiver 1, a microcomputer controller 2 for controlling the DAB receiver 1, an input unit 3 operated by a user, and a display unit 4 by which the user checks the state of reception. The microcomputer controller 2 comprises a CPU 7 and a memory 8. The CPU 7 executes programs stored in the memory 8 to control the input unit 3, the display unit 4, and the DAB receiver 1. Of these programs, a DAB control program 5 for controlling the DAB receiver 1 contains a broadcast program search program 6 in the prior art (Japanese Unexamined Patent Publication No. 10-107669).

This conventional broadcast receiving apparatus operates as follows.

To find a desired broadcast program, a user presses a key or the like on the input unit 3 to switch broadcast programs one after another, and checks each broadcast program by a sound generated from a loudspeaker or information displayed on the display unit. The user repeats this operation until he or she finds the desired program.

This prior art has the following problems.

To find a desired broadcast program, a user presses a key or the like to switch broadcast programs one after another, and checks each broadcast program by a sound generated from a loudspeaker or information displayed on the display unit. In the DAB broadcasting system, however, a plurality of broadcast programs each containing audio data and broadcast program information are multiplexed. Therefore, to find a desired broadcast program by, e.g., a program type (to be abbreviated as a PTY hereinafter) as one broadcast program information, it is necessary, owing to the DAB format, to search as many as 16,384 program types (6 bits of a coarse code and 8 bits of a fine code, a total of 2¹⁴ = 16,384). This operation is difficult and cumbersome.

Also, the conventional broadcast receiving apparatus requires the following operation. A user previously designates PTYs which he or she habitually listens to. From these PTYs, the user selects a PTY which he or she currently wants to search for or listen to, and searches for a broadcast program matching the selected PTY, by using the broadcast program search program 6 (a broadcast program searching means 56 in Japanese Unexamined Patent Publication No. 10-107669).

Unfortunately, the search item is limited to one PYT. Therefore, if the broadcast program desired by the user is not found as a result of search, the user may be forced to perform the aforementioned cumbersome operation.

Program types are, e.g., music, news, sport, and drama, and they are sometimes classified more finely. As an example, music is classified into classic, jazz, popular, and the like.

### SUMMARY OF THE INVENTION

The present invention has been made to solve the above problems of the prior art, and has as its object to provide a broadcast program search method in a digital broadcasting radio receiving apparatus by which a user can efficiently find a desired broadcast program, and a computer-readable storage medium recording a broadcast program search program.

To achieve the above object, a broadcast program search method in a digital broadcasting radio receiving apparatus of the present invention is a broadcast program search method in a digital broadcasting radio receiving apparatus which comprises a DAB receiver which receives a DAB digital signal and transfers broadcast program information data in the digital signal to a microcomputer controller, an input unit operated by a user, a CPU for executing a stored program, a memory for storing a program, a microcomputer controller which receives the broadcast program information data and executes control by the program, a display unit for checking the state of each DAB broadcast station program, a DAB control program which controls the DAB receiver and analyses the broadcast program information data from the DAB receiver, and a broadcast program search program which starts operation upon a key operation of a user, characterized by comprising the step of activating the broadcast program search program and switching to a broadcast program search mode, the step of selecting a search item and setting the search condition of the search item by an operation by a user, the search step of performing search by the search item selected by the user on the basis of the selection of the search item and the set search condition of the search item, the channel selection step of selecting a channel on the basis of the search result in the search step, and the step of checking whether to again perform search if the search is unsuccessful, repeating the setting under the set search condition if search is to be again performed, and terminating the broadcast program search program if no search is to be again performed.

A computer-readable storage medium recording a broadcast program search program of the present invention is a computer-readable storage medium recording a broadcast program search program for a digital broadcasting radio receiving apparatus which comprises a DAB receiver, a microcomputer controller which includes a CPU and a memory and controls the DAB receiver, an input unit operated by a user, a display unit for checking the state of reception, a program which is stored in the memory and controls the input unit, the display unit, and the DAB receiver, and a DAB control program which contains a broadcast program search program and controls the DAB receiver, characterized by comprising the process of activating the broadcast program search program and switching to a broadcast program search mode, the process of selecting a search item and setting the search condition of the search item by an operation by a user, the search process of performing search by the search item selected by the user on the basis of the selection of the search item and the set search condition of the search item, the channel selection process of selecting a channel on the basis of the search result in the search process, and the process of checking whether to again perform search if the search is unsuccessful, repeating the setting under the set search condition if search is to be again performed, and terminating the broadcast program search program if no search is to be again performed.

The effect of the present invention is clear from the above aspects. For example, if X types of PTYs, Y types of service labels, and Z types of service component labels are used, search takes about a few minutes when it is performed by checking sounds and displays. However, when the search method of the invention is used, search can be performed within a few tens of seconds. Also, a user need only perform key operations several times. This eliminates the need to perform a cumbersome operation, by which a user operates keys to find a desired broadcast program, which is a problem of the prior art.

In addition, a routine for storing search conditions in a memory obviates operation of setting search items. This can release a user from this troublesome operation. Also, in the invention, a PTY, a service label, and a service component label are used as search items. Therefore, unlike the conventional search in which the search item is limited to a PTY, a broadcast program desired by a user can be found without omission. Even if there is an omission, search can be again performed by changing the search conditions. Accordingly, search can again be performed even in a case where no broadcast program can be found by a PTY, which is a problem of the prior art.

The above and many other objects, features and advantages of the present invention will become manifest to those skilled in the art upon making reference to the following detailed description and accompanying drawings in which preferred embodiments incorporating the principle of the present invention are shown by way of illustrative examples.

### BRIEF DESCRIPTION OF THE DRAWINGS

Fig. 1 is a block diagram showing the arrangement of an example of a broadcast receiving apparatus used in the present invention;
Fig. 2 is a flow chart of a broadcast program search program according to the invention;
Fig. 3 is a flow chart of a search condition setting routine according to a first embodiment of the invention;
Fig. 4 is a flow chart of a search routine according to the first embodiment;
Fig. 5 is a flow chart of a PTY search routine according to the first embodiment;
Fig. 6 is a flow chart of a service label search routine according to the first embodiment;
Fig. 7 is a flow chart of a service component label search routine according to the first embodiment;
Fig. 8 is a channel selection routine according to the first embodiment;
Fig. 9 is a flow chart of a program information recording list formation routine according to a second embodiment of the invention;
Fig. 10 is a flow chart of a search condition setting routine according to a third embodiment of the invention;
Fig. 11 is a view showing the structure of a DAB transmission frame;
Fig. 12 is a view showing the structure of an FIB made up of 256 bits;
Fig. 13 is a view showing the structure of an FIG whose FIG type is 1(001) shown in Fig. 12;
Fig. 14 is a view showing the structure of a Type 1 field whose Extension is 2 in an FIG data field shown in Fig. 13;
Fig. 15 is a view showing the structure of a Type 1 field whose Extension is 1 in the FIG data field shown in Fig. 13, this Type 1 field containing data indicative of service label data; and
Fig. 16 is a view showing the structure of a Type 1 field whose Extension is 4 in the FIG data field shown in Fig. 13.

### DETAILED DESCRIPTION OF PREFERRED EMBODIMENTS

Several preferred embodiments of the present invention will be described below with reference to the accompanying drawings.

The broadcast receiving apparatus of Fig. 1 is a broadcasting receiver which operates by programs. This broadcast receiving apparatus includes a DAB receiver 1, a microcomputer controller 2, an input unit 3, and a display unit 4. The DAB receiver 1 receives a DAB digital signal and transmits broadcast program information data in the signal to the microcomputer controller 2. The input unit 3 is used by a user to perform key operations. The microcomputer controller 2 has a CPU 7 for detecting the state of the input unit 3 and executing programs stored in a memory 8. This microcomputer controller 2 operates by these programs. The display unit 4 displays the state of each broadcast program of DAB. The internal memory 8 of the microcomputer controller 2 contains a DAB control program 5 for, e.g., controlling the DAB receiver 1 and analyzing broadcast program information data from the DAB receiver 1, and a broadcast program search program 6 which starts operating when a user performs a specific key operation.

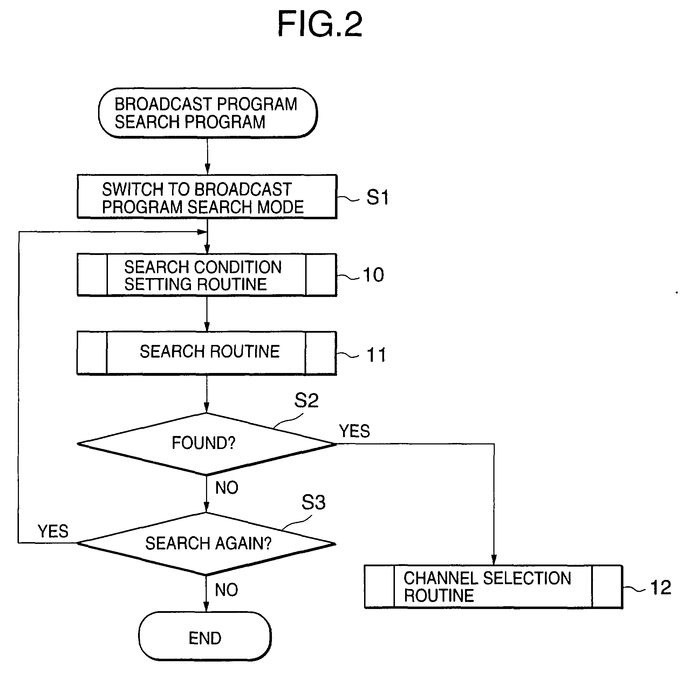

The overall operation of this embodiment will be described in detail below with reference to Fig. 1 and flow charts in Figs. 2 to 8.

First, when a user wishes to find a desired broadcast program, he or she performs specific key inputting on the input unit 3 shown in Fig. 1 to start the operation of the broadcast program search program 6 shown in Fig. 1 and switch to a broadcast program search mode (step S1 in Fig. 2). Next, the operation of a search condition setting routine 10 is started, and the user performs specific key inputting to select search items and set the search conditions of these search items. A search item is that specific information of a broadcast program, which is a condition for searching for the broadcast program.

After the search condition setting routine 10 is completed, a search routine 11 starts operating to perform search on the basis of the search items selected by the user. If the search routine 11 finds a broadcast program on the basis of the search items selected by the search condition setting routine 10 (step S2 in Fig. 2), the operation of a channel selection routine 12 is started. If no broadcast program is found (step S2 in Fig. 2), a message for prompting the user to perform a key input operation is displayed on the display unit 4 shown in Fig. 1 to determine whether to again perform search (step S3 in Fig. 2). If search is again to be performed (step S3 in Fig. 2), the operation of the search condition setting routine 10 is started. If no search is to be performed again (step S3 in Fig. 2), the broadcast program search program 6 is terminated.

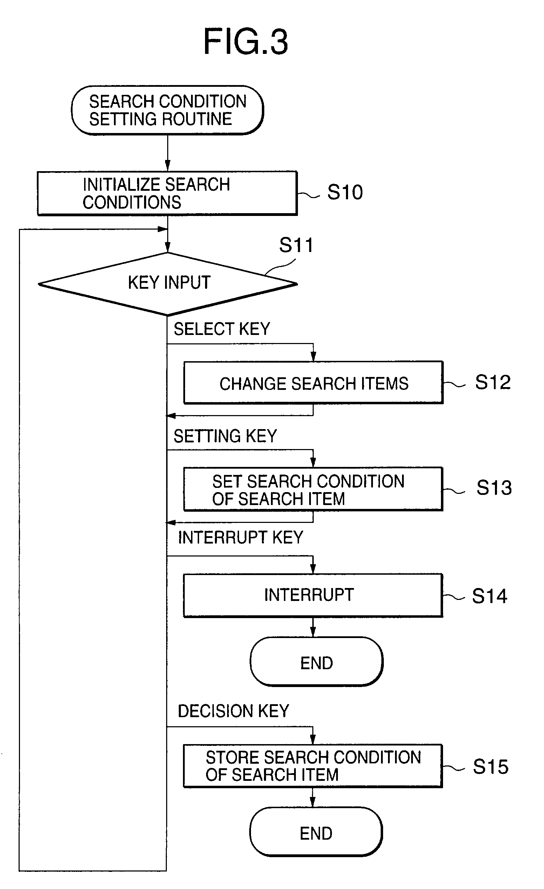

The operation of the search condition setting routine 10 is shown in the flow chart of Fig. 3. In this search condition setting routine 10, the conditions of search concerning a broadcast program desired by the user are set. First, a search condition list and a search result list to be set by the search condition setting routine 10 are initialized (step S10). The search condition list is a storage area for storing search conditions set for individual search items by a setting key (to be described later). When this search condition list is initialized, the operation of the search routine 11 shown in Fig. 2 need not be performed. The search result list is a storage area for storing the results of search by the search routine (to be described later). When this search result list is initialized, the broadcast program search program 6 can be terminated if the search result is NO in step S2, i.e., if the search condition setting routine 11 is interrupted or nothing can be found by the search routine 11.

Effective keys in Fig. 3 are a select key for selecting a search item, a setting key for setting a search condition for a selected search item, an interrupt key for interrupting the search condition setting routine 10, and a decision key for storing the search condition of each search item and making the search routine 11 operable. In step S11, whether a key is effective is checked. If the key is found to be effective, the operation of the key is performed. If this effective key is the select key, search items are changed (step S12). Examples of the search items are the PTY (a program type, e.g., news, music, and sport) of a broadcast program, a service label (a label which can be attached to a broadcast program), and a service component label (a label which can be attached to each individual broadcast content of a broadcast program). If the effective key is the setting key, the search condition of each search item is set (step S13). For example, if the search item is a PTY, the "program type" of a desired broadcast program is set to "news". If the effective key is the interrupt key, the search condition setting routine 10 is terminated (step S14). If the effective key is the decision key, the search conditions set by the select key and the setting key are stored in the search condition list, and the search condition setting routine 10 is terminated (step S15).

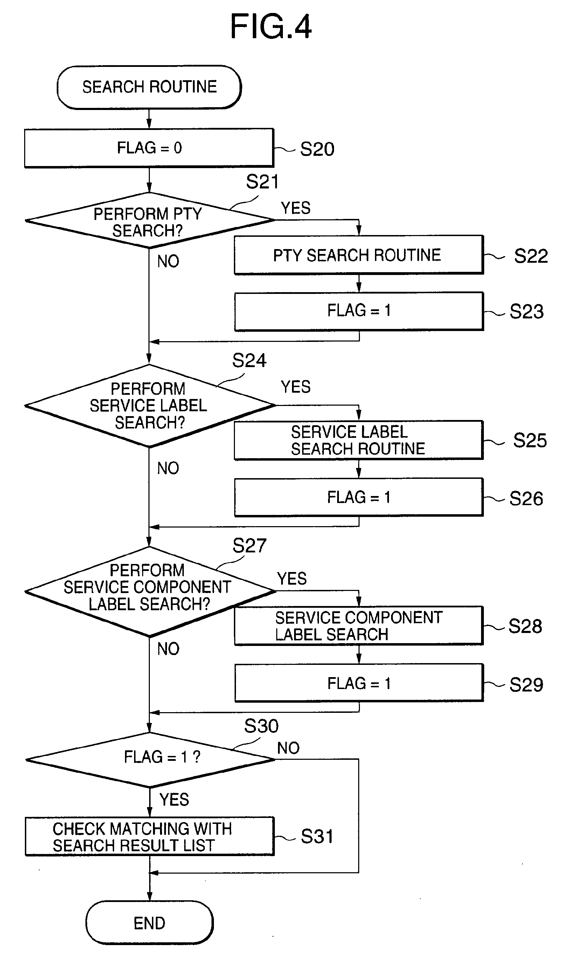

The operation of the search routine 11 is shown in the flow chart of Fig. 4. In this search routine 11, search is performed on the basis of the search conditions set in the search condition setting routine 10. For example, in Fig. 4 the search items set by the search condition setting routine 10 are a PTY, a service label, and a service component label. In step S20, Flag is set to 0. This Flag is used as determination data to check the matching with the search result list for storing the search result of each search item, i.e., to check whether to perform step S31 in which identical results for the same search item are removed.

Next, whether to perform PTY search is checked (step S21) by referring to the search condition list stored in the search condition setting routine 10. If the search is to be performed, a PTY search routine is executed (step S22), and Flag is set to 1 (step S23). After the operation of the PTY search routine is executed (step S22), or if no PTY search is to be performed, whether to perform service label search is checked (step S24) by referring to the search condition list stored in the search condition setting routine 10. If the search is to be performed, a service label search routine is executed (step S24), and Flag is set to 1 (step S26). After the operation of the service label search routine is executed (step S24), or if no service label search is to be performed, whether to perform service component label search is checked (step S27) by referring to the search condition list stored in the search condition setting routine 10. If the search is to be performed, a service component label search routine is executed (step S28), and Flag is set to 1 (step S29). After the operation of the service component label search routine is executed (step S28), or if no service component label search is to be performed, whether Flag is 1 is checked (step S30). If YES in step S30, identical results in the search result list are removed (step S31), and the search routine 11 is terminated. If NO in step S30, the search routine 11 is terminated.

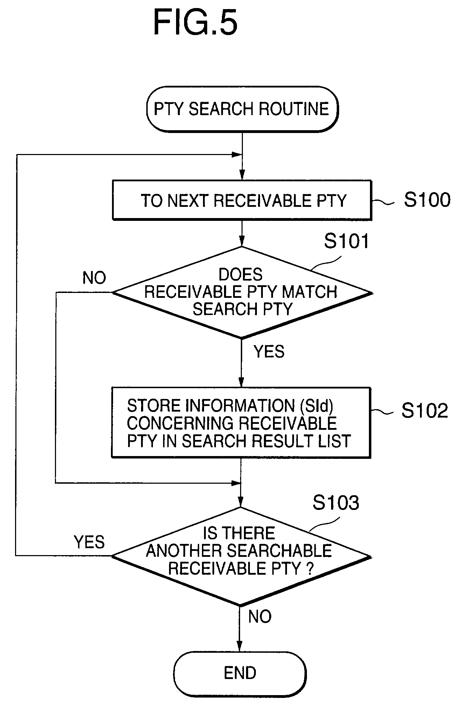

The operation of the PTY search routine is shown in the flow chart of Fig. 5. Broadcast program information on a broadcast wave received by the DAB receiver shown in Fig. 1 contains a plurality of receivable broadcast programs, and a broadcast program matching the PTY search condition is searched for. First, broadcast program information on a broadcast wave currently being received is searched for the PTY of a receivable broadcast program (step S100). Whether this receivable PTY matches the PTY of the search condition is checked (step S101). If YES in step S101, information pertaining to the receivable PTY is stored in the search result list (step S102). If NO in step S101, the flow advances to step S103. In step S103, whether another searchable receivable PTY exists is checked. If YES in step S103, the flow returns to step S100. If NO in step S103, the PTY search routine is terminated.

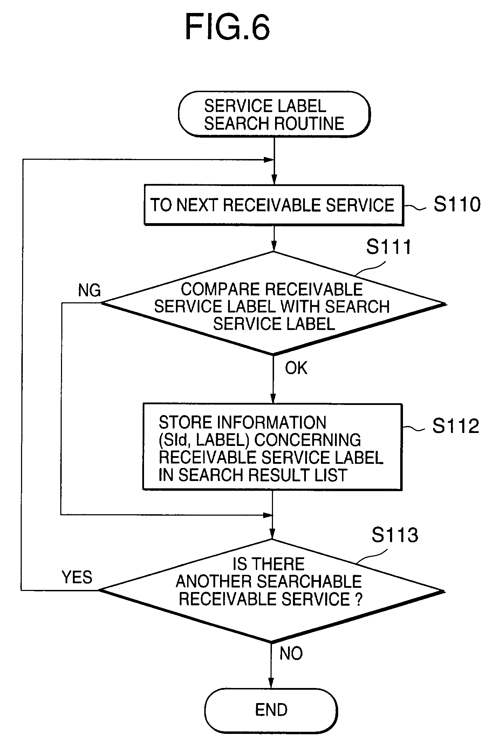

The operation of the service label search routine is shown in the flow chart of Fig. 6.

As explained in the PTY search routine of Fig. 5, broadcast program information on a broadcast wave currently being received contains a plurality of receivable broadcast programs, and a broadcast program matching the service label search condition is searched for. First, broadcast program information on a broadcast wave currently being received is searched for the service of a receivable broadcast program (step S110). The label of this receivable service is compared with the service label of the search condition (step S111). If the comparison result is OK, information (SId, label) pertaining to the receivable service is stored in the search result list. If the comparison result is NG, the flow advances to step S113. In step S113, whether another searchable receivable service exists is checked. If YES in step S113, the flow returns to step S110. If NO in step S113, the service label search routine is terminated.

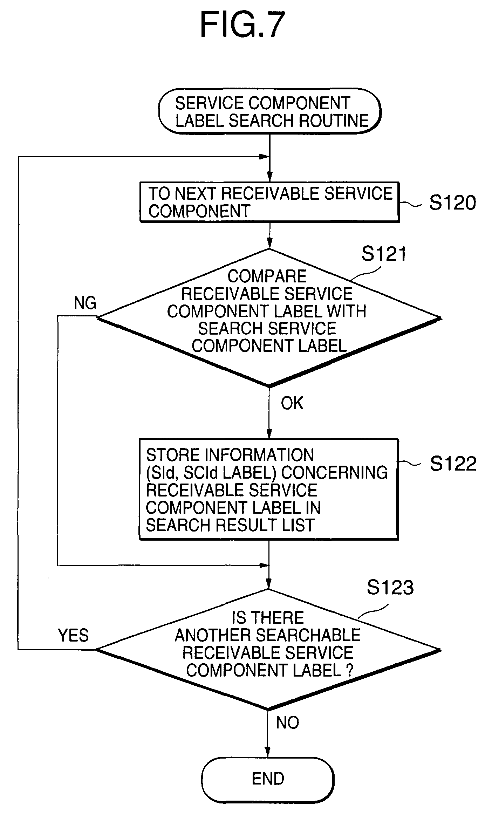

The operation of the service component label search routine is shown in the flow chart of Fig. 7.

As explained in the search routines of Figs. 5 and 6, broadcast program information on a broadcast wave currently being received contains a plurality of receivable broadcast programs, and a broadcast program matching the service component label search condition is searched for. First, broadcast program information on a broadcast wave currently being received is searched for the service component of a receivable broadcast program (step S120). The label of this receivable service component is compared with the service component label of the search condition (step S121). If the comparison result is OK, information (SId, SCId label) pertaining to the receivable service is stored in the search result list. If the comparison result is NG, the flow advances to step S123. In step S123, whether another searchable receivable service component exists is checked. If YES in step S123, the flow returns to step S120. If NO in step S123, the service component label search routine is terminated.

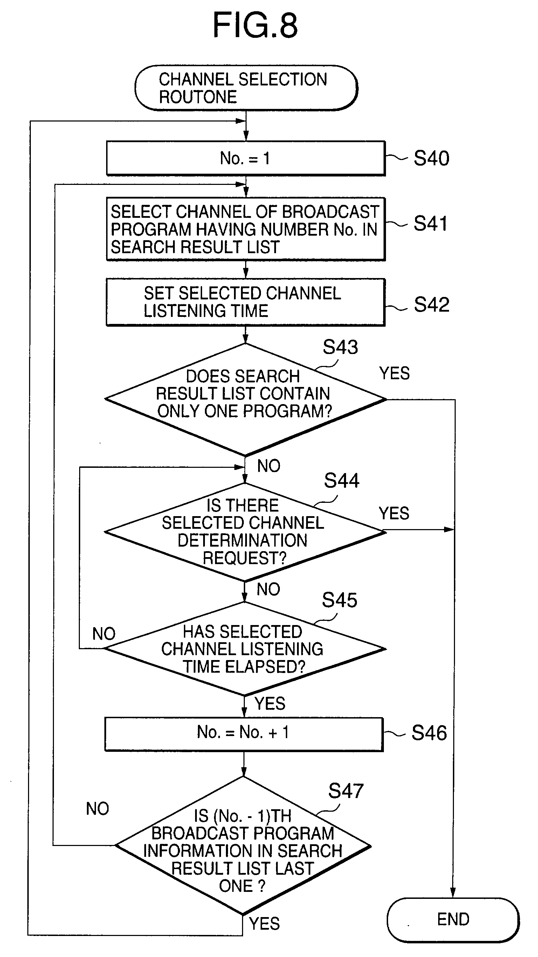

The operation of the channel selection routine 12 is shown in the flow chart of Fig. 8. In this channel selection routine 12, a channel is selected on the basis of the search result list stored in the search routine 11. First, No. is set to 1 (step S40). This No.indicates the number of information to be selected from the search result list. A channel having this number No. in the search result list is selected (step S41). A selected channel listening time is set (step S42). Whether the search result list records only one program is checked (step S43). If YES in step S43, the channel selection routine 12 is terminated. If NO in step S43, the flow advances to step S44. In step S44, whether the user has issued a selected channel determination request (a selected channel determination request is, e.g., to press a specific key if a program broadcast from a loudspeaker is the desired broadcast program). If YES in step S44, the channel selection routine 12 is terminated. If NO in step S44, the flow advances to step S45. In step S45, whether the selected channel listening time has elapsed is checked. If YES in step S45, the flow advances to step S46. If NO in step S45, the flow returns to step S44. In step S46, 1 is added to No. In step S47, whether the (No. - 1)th broadcast program information in the search result list is the last one is checked. If YES in step S47, the flow returns to step S40. If NO in step S47, the flow returns to step S41. In this manner, the channels of broadcast programs in the search result list are selected in turn.

The second embodiment of the invention will now be described.

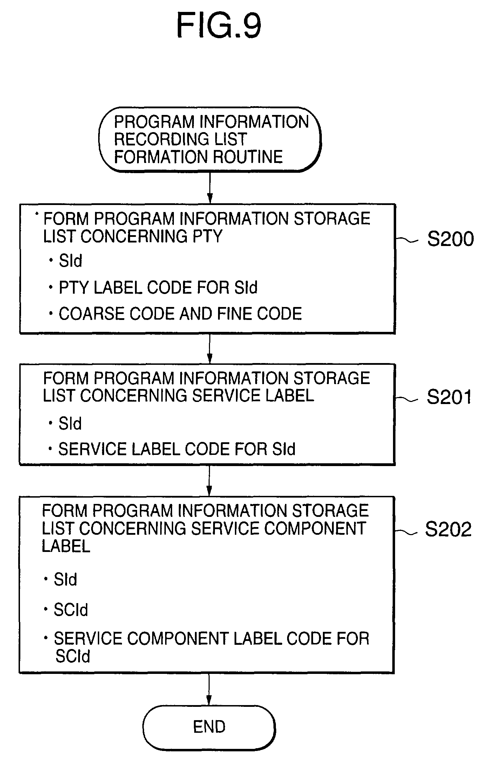

Referring to a flow chart of a program information recording list formation routine shown in Fig. 9, the embodiment comprises step S200 for forming a program information storage list concerning a PTY, step S201 for forming a program information storage list concerning a service label, and step S202 for forming a program information storage list concerning a service component label.

The overall operation of this embodiment will be described with reference to the flow charts in Figs. 2, 4, 5, 6, 7 and 9.

First, the program information storage list formation routine in Fig. 9 acquires program information pertaining to a PTY, a service label, and a service component label, during regular broadcasting reception, to be referred to when search is performed in the PTY search routine (step S22), the service label search routine (step S25), and the service component label search routine (step S28) shown in Fig. 4 which is a flow chart of the search routine 11 shown in Fig. 2. Data of the program information storage list formed by this program information storage list formation routine is compared with the search conditions in step S101 of the PTY search routine in Fig. 5, in step S111 of the service label search routine in Fig. 6, and in step S121 of the service component label search routine in Fig. 7. This improves the search speed and makes it possible to receive a broadcast program desired by a user.

The third embodiment of the present invention will now be described.

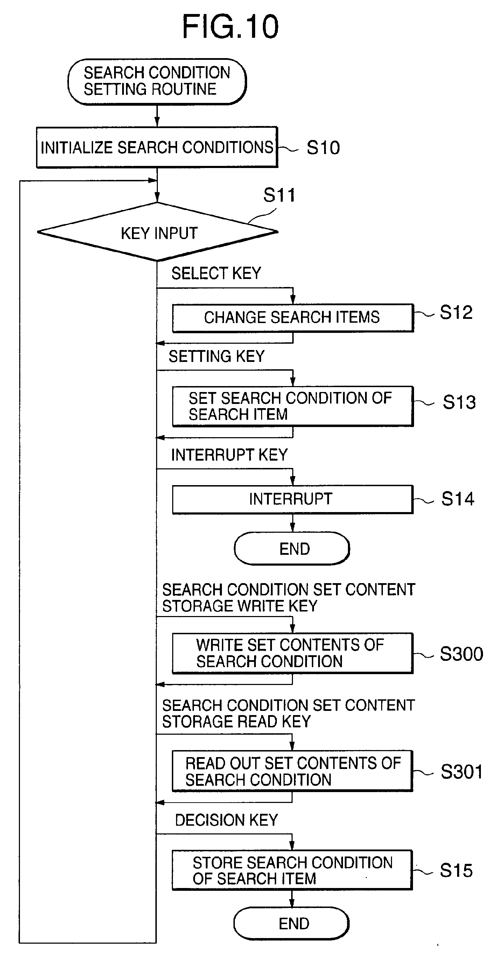

Fig. 10 is a flow chart of the search condition setting routine 10 in Fig. 2. In this embodiment, step S300 for storing the set contents of search conditions by a search condition set content storage write key and step S301 for reading out the set contents of search conditions by a search condition set content storage read key are added to Fig. 3 of the first embodiment.

Details of the overall operation of this third embodiment will be explained below with reference to the flow chart in Fig. 10. This flow chart shows the operation of the search condition setting routine 10 in Fig. 2, and performs an operation similar to the flow chart shown in Fig. 3.

In this embodiment, the operations of steps S300 and S301 added to the flow chart in Fig. 3 will be described. In step S11 of Fig. 10, whether a key is an effective key is checked. If the key is an effective key and this effective key is the search condition set content storage write key, a select key and a search condition set by the select key are written in a search condition storage list. The search condition storage list is a storage area for storing search conditions. If the effective key is the search condition set content storage read key, the contents of the search condition storage list are written in a search condition list. In this embodiment, a user can store the currently set search condition in the search condition storage list by using the search condition set content write key. For example, if a plurality of search condition set content storage write keys are available, the user can store a plurality of search conditions. To search for a desired broadcast program, the user can set desired search conditions at once by using the search condition set content storage read key. Since no search conditions need be input, search conditions can be efficiently set, i.e., search can be readily performed.

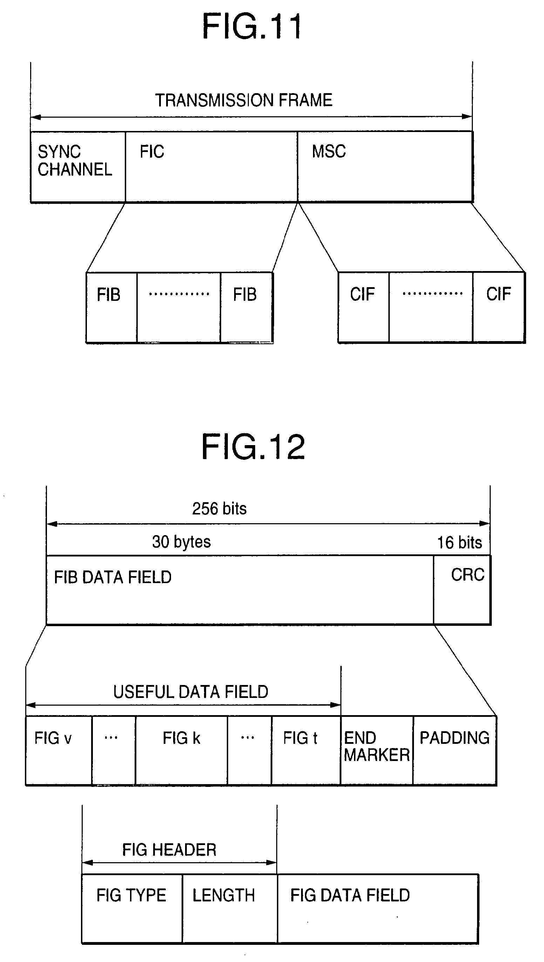

Figs. 11 to 16 illustrate information corresponding to individual search items of the embodiment.

Fig. 11 is a view showing the structure of a DAB transmission frame which has a sync channel, FIC (Fast Information Channel), and MSC (Main Service Channel). The FIC is made up of a plurality of FIBs (Fast Information Blocks), and the MSC is made up of a plurality of CIFs (Common Interleaved Frames). DAB forms a broadcast wave by carrying various pieces of information on this transmission frame.

Fig. 12 is a view showing the structure of the FIB. The FIB is composed of 256 bits and has a 30-byte FIB data field and a 16-bit CRC (Cycle Redundancy Check word). The FIB data field is made up of a plurality of FIGs (Fast Information Groups) as a useful data field, End marker, and Padding (an area for byte matching if 30 bytes of the FIG data field are not filled). Each FIG has FIG Type, Length (the bit length of an FIG data field subsequent to Length), and an FIG data field. FIG Type and Length form an FIG header.

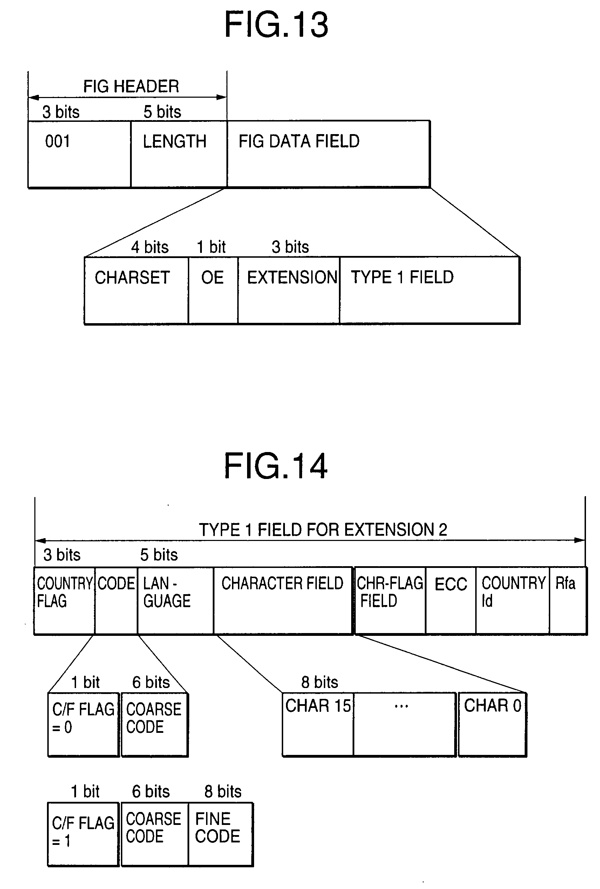

Fig. 13 shows an FIG whose FIG Type is 1(001), made up of Charset, OE (data indicating whether information in a Type 1 field belongs to this ensemble or another), Extension (the Extension number of FIG Type 1), and the Type 1 field.

Fig. 14 shows a Type 1 field when Extension in the FIG data field shown in Fig. 13 is 2. This Type 1 field contains Code which is data indicative of PTY data. Data following this Code changes in accordance with a C/F flag (Coarse/Fine flag): if the C/F flag is 0, the data is Coarse code (6 bits); if the C/F flag is 1, the data contains Coarse code and Fine code (8 bits).

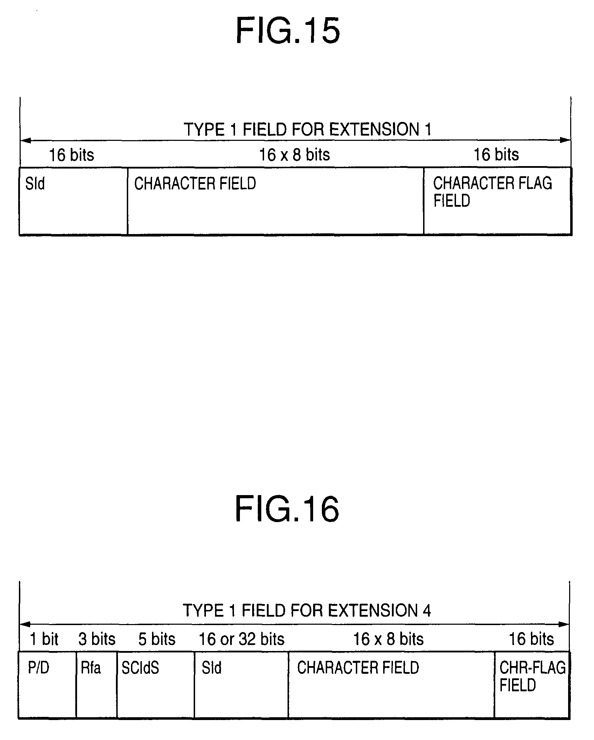

Fig. 15 shows the structure of a Type 1 field when Extension in the FIG data field shown in Fig. 13 is 1. This field contains service identification data (SId) indicating service label data, and a character data field (Character field). This character data field is the service label.

Fig. 16 shows a Type 1 field when Extension in the FIG data field shown in Fig. 13 is 4. This field contains service component identification data (SId) indicating service component data, service identification data (SId), and a character data field (Character field). This character data field is the service component label.

A computer-readable storage medium recording a broadcast program search program of the present invention will be described below with reference to the accompanying drawings.

Referring to Fig. 1, in an environment having a DAB receiver 1, a microcomputer controller 2 which controls the DAB receiver 1 and includes a CPU 7 and a memory 8, an input unit 3 operated by a user, and a display unit 4 for checking the state of reception, the computer-readable storage medium recording the broadcast program search program of the invention is a computer-readable storage medium recording a program which is stored in the memory 8 and controls the input unit 3, the display unit 4, and the DAB receiver 1, and the broadcast program search program of the invention contained in a DAB control program 5 for controlling the DAB receiver 1.

A broadcasting receiver which operates by programs includes the DAB receiver 1, the microcomputer controller 2, the input unit 3, and the display unit 4. The DAB receiver 1 receives a DAB digital signal and transmits broadcast program information data in the signal to the microcomputer controller 2. The input unit 3 is used by a user to perform key operations. The microcomputer controller 2 has the CPU 7 for detecting the state of the input unit 3 and executing programs stored in the memory 8. This microcomputer controller 2 operates by these programs. The display unit 4 displays the state of each broadcast program of DAB. The internal memory 8 of the microcomputer controller 2 contains the DAB control program 5 for, e.g., controlling the DAB receiver 1 and analyzing broadcast program information data from the DAB receiver 1, and a broadcast program search program 6 which starts operating when a user performs a specific key operation.

The broadcast program search program 6 is made up of a search condition setting routine 10 for, e.g., selecting a search item for searching for a broadcast program and setting the search condition of the search item, a search routine 11 for performing search by using the search item selected by a user, a channel selection routine 12 performed on the basis of the search by the search routine 11, and a control routine for controlling these routines.

The search condition setting routine 10 sets search conditions for a broadcast program desired by a user. Search items include a select key for selection, a setting key for setting the search condition of each search item, an interrupt key for interrupting the search condition setting routine 10, and a decision key for storing the search condition of each search key and making the search routine 11 operable. Examples of the select key are the PTY (a program type, e.g., news, music, and sport) of a broadcast program, a service label (a label which can be attached to a broadcast program), and a service component label (a label which can be attached to each different broadcast content of a broadcast program).

The search routine 11 performs search on the basis of the search conditions set by the search condition setting routine 10. For example, in this embodiment, the search items set by the search condition setting routine 10 are a PTY, a service label, and a service component label. To avoid duplicate search by each selected item, the search condition setting routine 10 removes identical results from a search result list. In the search routine 11, a PTY search routine, a service label search routine, and a service component label search routine are prepared. Broadcast program information on a broadcast wave currently being received contains a plurality of receivable broadcast programs. The search routine 11 searches these broadcast programs for one which matches the service label search condition.

The channel selection routine 12 selects a channel on the basis of a search result list stored in the search routine 11. In accordance with a number indicating the number of information to be selected from the search result list, the channel selection routine 12 selects a channel having the number No in the search result list, and sets a selected channel listening time. The channel selection routine 12 selects the channels of broadcast programs in the search result list in turn.

Description of the operation of the broadcast program search program may be omitted, because the search method using the broadcast program search program of the digital broadcasting radio receiving apparatus has already been explained in detail with reference to Fig. 1 and the flow charts in Figs. 2 to 8.

The second embodiment of the computer-readable storage medium recording the broadcast program search program will be described below. This embodiment comprises a routine for forming a broadcast program information storage list concerning a PTY, a routine for forming a broadcast program information storage list concerning a service label, and a routine for forming a broadcast program information storage list concerning a service component label. The operation of each routine has been described with reference to the flow charts in Figs. 2, 4, 5, 6, 7, and 9 in the second embodiment of the search method using the broadcast program search program, so a detailed description thereof may be omitted.

The third embodiment of the computer-readable storage medium recording the broadcast program search program will be described below.

In this embodiment, a routine for storing the set contents of a search condition set by a search condition set content storage write key and a routine for reading out the set contents of a search condition set by a search condition set content storage read key are added to Fig. 3 of the first embodiment of the search method using the broadcast program search program.

The operation of each routine has been explained with reference to the flow chart in Fig. 10 in the third embodiment of the search method using the broadcast program search program, so a detailed description thereof may be omitted.

## Claims

1. A broadcast program search method in a digital broadcasting radio receiving apparatus which comprises a DAB receiver, a microcomputer controller which includes a CPU and a memory and controls the DAB receiver, an input unit operated by a user, a display unit for checking the state of reception, a program which is stored in the memory and controls the input unit, the display unit, and the DAB receiver, and a DAB control program which contains a broadcast program search program and controls the DAB receiver, comprising:
the step of activating the broadcast program search program and switching to a broadcast program search mode;
the step of selecting a search item and setting the search condition of the search item by an operation by a user;
the search step of performing search by the search item selected by the user on the basis of the selection of the search item and the set search condition of the search item;
the channel selection step of selecting a channel on the basis of the search result in the search step; and
the step of checking whether to perform search again if the search is unsuccessful, repeating the setting under the set search condition if search is again to be performed, and terminating the broadcast program search program if no search is to be performed again.

2. A method according to claim 1, wherein the step of selecting a search item and setting the search condition of the search item comprises the steps of:
initializing a search condition list and a search result list; and
changing the program type, service label, and service component label, as search items, of a broadcast program by a select key of the input unit, setting the search condition of each search item by a setting key, interrupting the setting by an interrupt key, or storing the set search item and search condition in a search condition list by a decision key and terminating the step.

3. A method according to claim 1, wherein the search step comprises the steps of:
checking whether to sequentially perform PTY search for searching for a program type such as news, music, or sport, service label search for searching for a label attached to a broadcast program, and service component label search for searching for a label attached to each different broadcast content of a broadcast program, by referring to the search condition list, and, if search is to be performed, sequentially executing these search routines;
bypassing a search routine not to be performed, if the search routines are not to be performed sequentially; and
removing identical results in a search result list after a search routine is completed, and terminating the search.

4. A method according to claim 1, wherein the channel selection step comprises the steps of:
setting a number indicating a channel selection order, a channel selection number indicating the number of information to be selected, and a selected channel listening time;
terminating the channel selection if a search result list records only one broadcast program;
checking whether a user has issued a selected channel determination request if the search result list records more than one broadcast program, and terminating the channel selection if the user has issued the selected channel determination request; and
checking whether the selected channel listening time has elapsed if the user has not issued a selected channel determination request, and, if the selected channel listening time has elapsed, adding 1 to the channel selection order number and selecting the channels of broadcast programs in the search result list in turn.

5. A broadcast program search method in a digital broadcasting radio receiving apparatus which comprises a DAB receiver, a microcomputer controller which includes a CPU and a memory and controls the DAB receiver, an input unit operated by a user, a display unit for checking the state of reception, a program which is stored in the memory and controls the input unit, the display unit, and the DAB receiver, and a DAB control program which contains a broadcast program search program and controls the DAB receiver, comprising the steps of:
searching broadcast program information on a broadcast wave currently being received for program information concerning a PTY, a service label, and a service component label, during regular reception, by using a search routine for forming a program information storage list concerning PTY search, a search routine for forming a program information storage list concerning service label search, and a search routine for forming a program information storage list concerning service component label search; and
referring to data of the program information storage lists formed by the search routines for forming the program information storage lists, in order to compare the data with search conditions, by using a PTY search routine, a service label search routine, and a service component search routine, thereby rapidly receiving a broadcast program desired by a user.

6. A method according to claim 1, wherein
the step of selecting a search item and setting the search condition of the search item comprises the steps of:
storing the set contents of the search condition by a search condition set content storage write key;
reading out the set contents of the set condition by a search condition set content storage read key; and
writing the search condition in a search condition storage list by the search condition set content storage write key, and writing the contents of the search condition storage list into a search condition list by the search condition set content storage read key, and
if there are a plurality of search condition set contents to be stored, a user stores a plurality of search conditions by the search condition set content write key, and searches for a desired broadcast program by setting desired search conditions at once by the search condition set content storage read key, thereby improving the efficiency of search condition setting.

7. A computer-readable storage medium recording a broadcast program search program for a digital broadcasting radio receiving apparatus which comprises a DAB receiver, a microcomputer controller which includes a CPU and a memory and controls the DAB receiver, an input unit operated by a user, a display unit for checking the state of reception, a program which is stored in the memory and controls the input unit, the display unit, and the DAB receiver, and a DAB control program which contains a broadcast program search program and controls the DAB receiver, comprising:
the process of activating the broadcast program search program and switching to a broadcast program search mode;
the process of selecting a search item and setting the search condition of the search item by an operation by a user;
the search process of performing search by the search item selected by the user on the basis of the selection of the search item and the set search condition of the search item;
the channel selection process of selecting a channel on the basis of the search result in the search process; and
the process of checking whether to perform search again if the search is unsuccessful, repeating the setting under the set search condition if search is to be performed again, and terminating the broadcast program search program if no search is to be performed again.

8. A medium according to claim 7, wherein the process of selecting a search item and setting the search condition of the search item comprises the processes of:
initializing a search condition list and a search result list; and
changing the program type, service label, and service component label, as search items, of a broadcast program by a select key of the input unit, setting the search condition of each search item by a setting key, interrupting the setting by an interrupt key, or storing the set search item and search condition in a search condition list by a decision key and terminating the process.

9. A medium according to claim 7, wherein the search process comprises the processes of:
checking whether to perform sequentially PTY search for searching for a program type such as news, music, or sport, service label search for searching for a label attached to a broadcast program, and service component label search for searching for a label attached to each different broadcast content of a broadcast program, by referring to the search condition list, and, if search is to be performed, sequentially executing these search routines;
bypassing a search routine not to be performed, if the search routines are not to be sequentially performed; and
removing identical results in a search result list after a search routine is completed, and terminating the search.

10. A medium according to claim 7, wherein the channel selection process comprises the processes of:
setting a number indicating a channel selection order, a channel selection number indicating the number of information to be selected, and a selected channel listening time;
terminating the channel selection if a search result list records only one broadcast program;
checking whether a user has issued a selected channel determination request if the search result list records more than one broadcast program, and terminating the channel selection if the user has issued the selected channel determination request; and
checking whether the selected channel listening time has elapsed if the user has not issued a selected channel determination request, and if the selected channel listening time has elapsed, adding 1 to the channel selection order number and selecting the channels of broadcast programs in the search result list in turn.

11. A computer-readable storage medium recording a broadcast program search program for a digital broadcasting radio receiving apparatus which comprises a DAB receiver, a microcomputer controller which includes a CPU and a memory and controls the DAB receiver, an input unit operated by a user, a display unit for checking the state of reception, a program which is stored in the memory and controls the input unit, the display unit, and the DAB receiver, and a DAB control program which contains a broadcast program search program and controls the DAB receiver, comprising the processes of:
searching broadcast program information on a broadcast wave currently being received for program information concerning a PTY, a service label, and a service component label, during regular reception, by using a search routine for forming a program information storage list concerning PTY search, a search routine for forming a program information storage list concerning service label search, and a search routine for forming a program information storage list concerning service component label search; and
referring to data of the program information storage lists formed by the search routines for forming the program information storage lists, in order to compare the data with search conditions, by using a PTY search routine, a service label search routine, and a service component search routine, thereby rapidly receiving a broadcast program desired by a user.

12. A medium according to claim 7, wherein
the process of selecting a search item and setting the search condition of the search item comprises the processes of:
storing the set contents of the search condition by a search condition set content storage write key;
reading out the set contents of the set condition by a search condition set content storage read key; and
writing the search condition in a search condition storage list by the search condition set content storage write key, and writing the contents of the search condition storage list into a search condition list by the search condition set content storage read key, and
if there are a plurality of search condition set content write keys, a user stores a plurality of search conditions by the search condition set content write keys, and searches for a desired broadcast program by setting desired search conditions at once by the search condition set content storage read key, thereby improving the efficiency of search condition setting.
